# DEMANDE DE BREVET EUROPEEN

(11) **EP 0 545 839 A1**
(43) Date de publication de la demande: **09.06.1993**
(21) Numéro de dépôt: 92470028.9
(22) Date de dépôt: 22.10.1992
(51) Int. Cl.: C23C 14/00, C23C 28/00, C23C 14/08, C23C 14/12, C23C 14/06

(54) **Procédé de revêtement d'un produit métallurgique, produit ainsi obtenu et dispositif pour sa fabrication**

(30) Priorité: 04.11.1991 FR 9113720
(71) Demandeur: SOLLAC, F-92800 Puteaux (FR)
(72) Inventeur: Schuster, Frédéric, F-78100 Saint Germain en Laye (FR); Mongrelet, Thierry, F-78780 Maurecourt (FR); Segui, Yvan, F-31280 Mons (FR); Barreau, Corinne, F-78100 Saint Germain en Laye (FR); Lecuyer, Carole, F-78100 Saint Germain en Laye (FR)
(74) Mandataire: Ventavoli, Roger

(57) **Abrégé**

L'invention a pour objet un procédé de revêtement d'un produit métallurgique (5), caractérisé en ce qu'on dépose en alternance sur la surface dudit matériau, au moyen de traitements superficiels de pulvérisation réactive utilisant un plasma froid généré dans une enceinte (1) sous pression réduite, au moins une couche d'un oxyde métallique et au moins une couche d'un polymère organique.

## Description

La présente invention concerne le revêtement des produits métallurgiques, dans le but de les protéger contre la corrosion.

Le revêtement de produits métallurgiques par des procédés utilisant un plasma froid est à présent bien connu. Il est classique de revêtir ainsi de tels produits, par exemple des tôles d'aciers nues ou galvanisées, soit par une couche d'un métal pur ou d'un mélange de métaux purs, soit par une couche d'oxyde métallique ou d'un mélange d'oxydes métalliques, soit par une couche de polymère. Ces revêtements sont déposés dans l'un ou plusieurs des buts suivants :
- protection du produit de base contre la corrosion ;
- augmentation de sa dureté superficielle ;
- préparation de sa surface en vue d'un traitement ultérieur ;
- si la couche est relativement épaisse, coloration de la surface du produit qui prend la couleur intrinsèque du matériau déposé ;
- si la couche est très mince (jusqu'à quelques centaines d'Å), coloration de la surface du produit par un phénomène d'interférences lumineuses.

La couche d'oxyde métallique peut être formée de diverses manières. L'une des plus simples consiste à générer un plasma froid ou basse température (c'est-à-dire à une température maximale de quelques centaines de degrés, par opposition aux plasmas de fusion thermonucléaire) par décharge électroluminescente entre deux électrodes reliées à un générateur de courant alternatif ou continu et placées dans une enceinte à l'atmosphère raréfiée. Le produit à revêtir est placé entre ces électrodes, ou tient lui-même lieu d'anode, tandis que la cathode est en un matériau composé du métal ou des métaux dont on désire déposer les oxydes sur le produit. Par ailleurs, l'atmosphère raréfiée renferme de l'oxygène ou un gaz oxygéné, ce qui provoque l'oxydation des atomes métalliques arrachés à la cathode (ou aux deux électrodes si on travaille en courant alternatif) et le dépôt des oxydes sur le produit. De tels procédés sont décrits par exemple dans le document FR 2 648 478. Les oxydes déposés sont souvent des oxydes de fer, d'acier inoxydable, de chrome, de titane, d'aluminium. Un autre procédé consiste à introduire dans l'enceinte un composé organométallique à l'état gazeux, dont la molécule renferme à la fois de l'oxygène et le métal dont on veut déposer l'oxyde (voir le document WO 86106105). Entre les électrodes, on peut imposer soit une tension alternative, soit une tension continue.

Quant au dépôt de polymère, il est effectué généralement en générant un plasma radiofréquence entre deux électrodes dans une atmosphère raréfiée contenant le monomère du polymère à déposer. Le polymère se dépose sur l'échantillon qui est placé entre les électrodes ou au contact de l'une d'elles. Les documents JP 87079505 et JP 87011308, par exemple, décrivent de tels procédés. Les polymères déposés sont habituellement des polysilanes, polysiloxanes ou polyalcanes, car ils constituent de bonnes barrières contre l'humidité. Ce dépôt peut également, selon le document US 4981713, être effectué en courant continu, l'échantillon à revêtir étant placé à la cathode.

En matière de protection contre la corrosion, les revêtements par une couche d'oxyde et par une couche de polymère habituellement pratiqués ont des efficacités comparables, d'autant plus grandes que les couches sont plus épaisses. On peut cependant désirer obtenir une efficacité encore supérieure, sans devoir pour autant augmenter exagérément l'épaisseur du dépôt.

Le but de l'invention est de proposer une méthode pour augmenter l'efficacité de la protection contre la corrosion procurée par un traitement superficiel par plasma froid d'un produit métallurgique, tout en maintenant l'épaisseur du dépôt protecteur ainsi obtenu dans des proportions raisonnables.

A cet effet, l'invention a pour objet un procédé de revêtement d'un produit métallurgique, caractérisé en ce qu'on dépose en alternance sur la surface dudit matériau, au moyen de traitements superficiels de pulvérisation réactive utilisant un plasma froid généré dans une enceinte sous pression réduite, au moins une couche d'un oxyde métallique et au moins une couche d'un polymère organique.

L'invention a également pour objets des dispositifs pour la mise en oeuvre de ce procédé, et les produits métallurgiques qu'ils permettent d'obtenir.

Comme on l'aura compris, l'invention consiste à associer au moins une couche d'oxyde métallique à au moins une couche de polymère organique déposées en alternance sur le matériau métallurgique à revêtir. Cette association permet l'obtention de propriétés anti-corrosion très sensiblement supérieures à celles que procurerait l'utilisation d'oxyde ou de polymère seuls, par un effet de de synergie.

Il est bien entendu que par "oxyde métallique", on entend également un mélange quelconque d'oxydes métalliques, résultant par exemple de l'oxydation d'un acier allié, tel qu'un acier inoxydable.

L'invention sera mieux comprise à la lecture de la description qui suit, faisant référence aux figures suivantes :
- la figure 1 qui montre vue en coupe un exemple d'installation permettant de traiter des tôles à l'unité ;
- la figure 2 qui montre vue en coupe un exemple d'installation permettant de traiter des tôles conditionnées en bobines ;
- la figure 3 qui montre une variante de l'installation de la figure 2.

Lorsque l'on doit revêtir une pièce unitaire, telle qu'une tôle métallique, par le procédé selon l'invention, la manière la plus simple de procéder est de réaliser le dépôt de la première couche dans un appareil de type classique adapté à la formation d'un tel dépôt, puis de transférer la pièce dans un autre appareil qui est, lui, adapté à la formation du dépôt de la deuxième couche. C'est ainsi que différentes combinaisons peuvent être imaginées entre les procédés suivants, ou d'autres conduisant à des résultats similaires.

Pour le dépôt d'oxyde, on peut utiliser :
- une installation fonctionnant en courant continu et créant, dans une enceinte sous pression réduite (généralement inférieure à 1000 Pa), un plasma par décharge électroluminescente entre une cathode composée du métal dont on veut déposer l'oxyde (par exemple un acier inoxydable) et une anode constituée par le produit à revêtir, et dans laquelle on introduit de l'oxygène ou un gaz dont la molécule contient de l'oxygène ;
- une installation similaire à la précédente, mais où le produit à revêtir est placé entre la cathode et l'anode, et simplement maintenu à un potentiel supérieur à celui de la cathode ;
- une installation dans laquelle on introduit à l'état gazeux un composé organométallique dont la molécule renferme à la fois de l'oxygène et le métal dont on veut déposer l'oxyde, et entre les électrodes de laquelle on maintient une tension alternative ou continue, le produit pouvant être ou non mis au contact de l'une des électrodes.

L'épaisseur du dépôt d'oxyde est généralement de 500 à 5000 Å.

Pour le dépôt de polymère, on peut opérer en introduisant sous forme gazeuse, dans une enceinte sous pression réduite munie de deux électrodes alimentées en courant alternatif ou continu, le monomère dudit polymère. Celui-ci, par des mécanismes réactionnels non encore complètement élucidés, se dépose sur le produit qui est solidaire de l'une des électrodes ou placé entre elles. Les silicones, tels que les polysilanes et polysiloxanes, mais aussi les polyalcanes et les polyalcanes halogénés sont le plus souvent utilisés. L'épaisseur du dépôt est généralement de 500 Å à 3 µm.

Des installations permettant de réaliser ces différentes opérations sont décrites notamment dans les documents cités dans l'introduction de cette description.

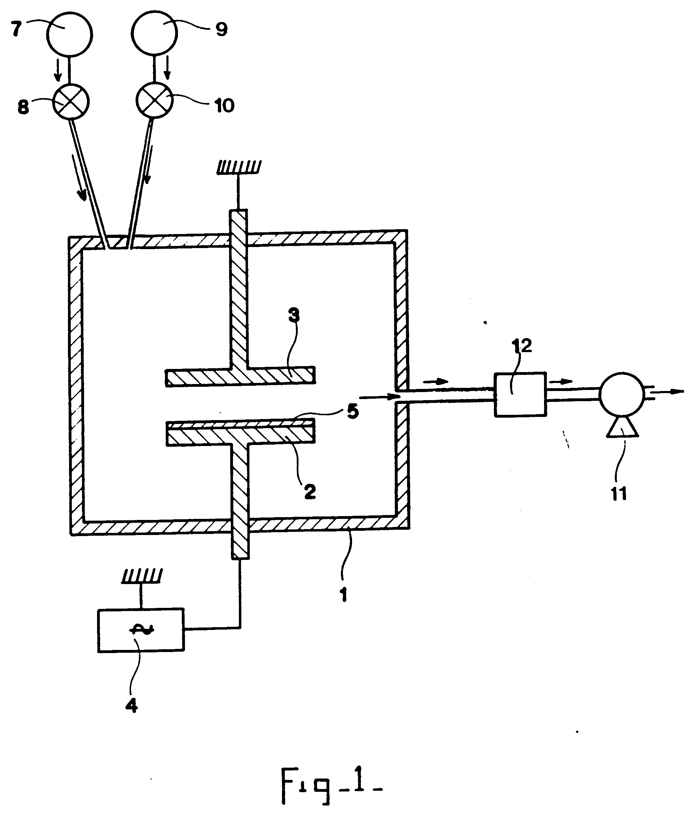

Dans un exemple particulier de mise en oeuvre de l'invention, on peut cependant réaliser les deux types de dépôt dans le même appareil, ce qui conduit à d'évidents gains de productivité et économies d'investissement. La figure 1 représente une installation adaptée à un tel traitement.

Une enceinte étanche 1 est équipée de deux électrodes 2, 3. L'électrode 2 est reliée à un générateur de courant alternatif 4, alors que l'électrode 3 est reliée à la terre. La partie électrique de l'installation comprend également des moyens non représentés de mesure et de contrôle des paramètres électriques, du type de ceux habituellement rencontrés sur les installations de traitement par plasma basse température fonctionnant en courant alternatif. On peut ainsi régler la tension entre les électrodes et l'intensité du courant qui les traverse. La tôle métallique 5 à revêtir est placée sur l'électrode 2 et expose sa surface à revêtir à l'atmosphère de l'enceinte. Cette atmosphère est contrôlée au moyen d'une pompe 6 permettant de maintenir la pression totale dans l'enceinte 1 dans la gamme 0,1-1000 Pa, et d'une installation permettant l'injection d'un monomère gazeux dans l'enceinte. Cette installation comprend un réservoir 7 renfermant le monomère d'un silicone destiné à former une couche sur la tôle 5. Ce monomère est, par exemple, un siloxane, tel que l'hexaméthyldisiloxane, et se trouve dans des conditions de température et de pression telles qu'il peut s'échapper du réservoir 7 à l'état gazeux. Son débit est contrôlé par une vanne 8. L'installation comprend de même un deuxième réservoir 9 contenant de l'oxygène. La vanne 10 permet de contrôler son débit de sortie, avant sa pénétration dans l'enceinte 1. L'installation est, bien entendu, également pourvue de tous les moyens non représentés connus et nécessaires pour la mesure des débits respectifs des différentes espèces gazeuses. L'installation comprend enfin une pompe 11 assurant la régulation de la pression à l'intérieur de l'enceinte 1. Entre cette pompe 11 et l'enceinte 1, les gaz aspirés passent par un piège à azote liquide 12 dans lequel se condense la fraction du monomère de silicone gazeux qui n'a pas réagi, et peut donc ainsi être récupérée.

L'installation est utilisée comme suit. Le vide est d'abord fait dans l'enceinte grâce à la pompe 11 jusqu'à une pression de l'ordre de 1 Pa. Puis le monomère de silicone et l'oxygène sont introduits simultanément dans l'enceinte 1 par ouverture des vannes 8 et 10, dans des proportions déterminées. Lorsque la pression s'est stabilisée au niveau désiré, on met en route le processus de formation du plasma en appliquant une différence de potentiel alternative entre les électrodes 2 et 3. Si les proportions respectives du monomère et de l'oxygène ont été correctement choisies, la réaction de formation et de dépôt de silice sur le produit à revêtir 5 est très prédominante par rapport à la formation de polysiloxane. Lorsque l'épaisseur désirée pour la couche de silice est atteinte, l'admission d'oxygène est arrêtée, et la réaction de polymérisation et de dépôt de polysiloxane sur le produit 5 est seule à se poursuivre. Lorsque l'épaisseur désirée pour le dépôt de polysiloxane est atteinte, l'admission du monomère est à son tour arrêtée, le générateur 4 est déconnecté, le vide est cassé, et le produit 5 revêtu est sorti de l'enceinte 1.

Les temps de traitement nécessaires pour obtenir les épaisseurs désirées pour les différentes couches, dans des conditions opératoires données, peuvent être facilement déterminés par l'expérience.

La méthode d'utilisation précédente conduit à la formation d'une interface franche entre les deux couches. Pour améliorer l'adhérence entre ces deux couches, on peut créer une "interface diffuse" entre elles en procédant de la manière suivante. En fin de formation de la couche de silice, on ferme graduellement la vanne 10 qui commande l'admission d'oxygène et non pas brusquement comme précédemment. Ainsi, pendant la période durant laquelle la vanne 10 a une ouverture plus faible que son ouverture nominale mais non nulle, se produit un dépôt simultané de silice et de polysiloxane, la proportion de polysiloxane augmentant progressivement. On crée ainsi, entre les deux couches de silice et de polysiloxane purs, une zone, dite "interface diffuse", dans laquelle silice et polysiloxane sont intimement mêlés, la proportion de polysiloxane dans ce mélange augmentant au fur et à mesure qu'on se rapproche de la surface libre du dépôt.

A titre d'exemple, le tableau 1 montre les capacités de résistance à la corrosion de différents produits. Cette résistance à la corrosion est traduite par la résistance de polarisation du revêtement, évaluée lors de mesures d'impédance d'un échantillon du produit nu ou revêtu, après un temps d'exposition variable (1 h et 6 h) à une solution aqueuse corrosive de NaCl 0,03 M. En l'espèce, on a pris les cas d'une tôle d'acier nue laminée à froid, d'une tôle similaire revêtue d'une couche d'oxyde d'acier inoxydable d'épaisseur 2000 Å déposée par pulvérisation cathodique réactive, d'une tôle similaire revêtue d'une couche de polyhexaméthyldisiloxane d'épaisseur 1 µm déposée par traitement plasma en courant alternatif, et d'une tôle similaire revêtue successivement et dans cet ordre de deux couches identiques à celles que l'on vient de citer.

| | Résistance à la polarisation (Ωcm²) | |
|---|---|---|
| Produits | exposition 1 heure | exposition 6 heures |
| Tôle nue | 700 | 900 |
| Tôle + oxyde d'inox 2000 Å | 1 100 | 700 |
| Tôle + polysiloxane 1 µm | 1 200 | 1 700 |
| Tôle + oxyde d'inox 2000 Å + polysiloxane 1 µm | 250 000 | 25 000 |

On voit que les propriétés protectrices des deux couches uniques d'oxydes et de polymère sont relativement médiocres. En particulier, au bout de 6 heures d'exposition, la tôle revêtue d'oyxde d'inox ne se distingue pas significativement de la tôle nue. En revanche la tôle revêtue des deux couches protectrices superposées présente une résistance de polarisation très notablement et durablement plus élevée que les autres, et très supérieure à ce qu'on aurait pu attendre a priori pour un revêtement monocouche d'épaisseur équivalente. Il y a donc une synergie entre les propriétés protectrices des différents matériaux mis en jeu, qui rend particulièrement avantageuse la superposition de couches protectrices d'oxyde et de polymère.

L'ordre des deux couches peut être inversé par rapport à cet exemple. De même, sans sortir de l'esprit de l'invention, on peut multiplier le nombre de couches, l'essentiel étant de retrouver cette alternance oxyde/polymère dans au moins une zone du revêtement.

Le dispositif qui vient d'être décrit s'applique au traitement de pièces unitaires, telles que des tôles déjà découpées, qui sont ainsi revêtues sur une seule de leurs faces. Si on désire que les deux faces de la tôle soient revêtues il faut alors placer la tôle entre les électrodes et non au contact de l'une d'elles.

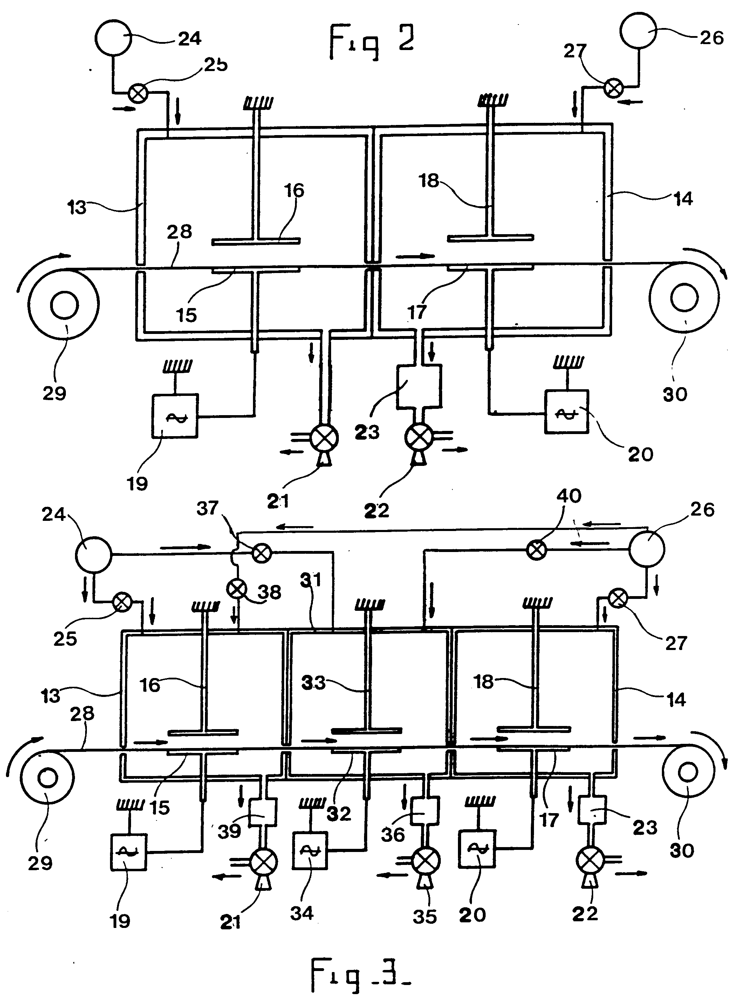

On peut également désirer revêtir en continu des tôles en défilement conditionnées sous forme de bobines. La figure 2 schématise une installation adaptée à un tel traitement. Elle est composée de deux enceintes accolées 13, 14 comprenant chacune un couple d'électrodes 15, 16 et 17, 18 reliées à des générateurs de courant alternatif 19, 20. Ces enceintes 13, 14 sont chacune reliées à une pompe 21, 22 permettant la régulation de leurs pressions intérieures entre 0,1 et 1000 Pa environ. Entre l'enceinte 14 et la pompe 22 est interposé un piège à azote liquide 23. L'enceinte 13 est reliée à un réservoir 24 contenant un composé organométallique dont la molécule renferme à la fois de l'oxygène et le métal dont on veut déposer l'oxyde, et muni d'une vanne 25. L'enceinte 14 est reliée à un réservoir 26 contenant le monomère du polymère à déposer, et muni d'une vanne 27. La tôle à revêtir 28, préalablement conditionnée sous forme d'une bobine 29, est mise en défilement par des moyens classiques non représentés, et traverse successivement les deux enceintes 13, 14 avant de s'enrouler sous forme d'une bobine 30 après sa sortie de l'enceinte 14. Des moyens sont prévus pour garantir l'étanchéité des enceintes 13 et 14 entre elles et vis-à-vis de l'extérieur aux points d'entrée et de sortie de la tôle 28. Des moyens non représentés sont également prévus pour garantir le contact entre la tôle 28 et les électrodes 15 et 17. Le monomère qui n'a pas réagi est recueilli dans le piège à azote liquide 23. Comme précédemment, on peut choisir de revêtir les deux faces de la tôle 28 en la faisant défiler entre les électrodes, et non au contact de l'une d'entre elles. Une autre façon de réaliser ce revêtement des deux faces consiste à prévoir dans chaque enceinte un deuxième couple d'électrodes agissant de manière symétrique au premier. L'enceinte 13 est le siège du dépôt de la couche d'oxyde, et l'enceinte 14 est le siège du dépôt de polymère. Dans ce cas, la séparation entre les deux couches est franche. On peut également éloigner les enceintes l'une de l'autre pour éviter d'éventuels problèmes d'étanchéité entre elles. Une telle disposition aurait cependant l'inconvénient d'exposer à l'air libre la surface du premier polymère, ce qui entraîne un risque de pollution préjudiciable à la bonne adhérence de la couche de polymère hydrophile.

Bien entendu, toute autre méthode que celle qui vient d'être décrite peut être utilisée pour le dépôt de la couche d'oxyde, par exemple la pulvérisation réactive en courant continu. Le générateur 19 délivrerait alors un courant continu, l'électrode 16 serait placée en cathode et faite dans le métal dont on veut déposer l'oxyde, et le réservoir 24 contiendrait de l'oxygène.

Si, dans une installation de ce type, on désire créer entre les deux couches de polymère une interface qui se rapproche de l'interface diffuse dont il a été précédemment question, on peut appliquer le procédé mis en oeuvre sur l'installation de la figure 1 en modifiant l'installation de la figure 2, notamment en lui ajoutant au moins une enceinte supplémentaire, comme représenté sur la figure 3. Sur cette figure, les organes communs avec l'installation de la figure 2 sont repérés par les mêmes références. L'enceinte supplémentaire 31 est insérée entre les enceintes 13 et 14. Comme elles, elle est munie d'électrodes 32, 33 reliées à un générateur de courant alternatif 34, la tôle 28 en défilement étant au contact de l'électrode 32. Une pompe 35 assure le maintien dans l'enceinte 31 de la pression désirée, et son circuit comprend un piège à azote liquide 36. Le réservoir 24 contient, cette fois, de l'oxygène, et est relié aux enceintes 13 et 31, où son débit d'introduction est contrôlé par les vannes 25 et 37. Le réservoir 26 contient à l'état gazeux un monomère de silicone tel qu'un silane ou un siloxane, et est relié aux trois enceintes 13, 31 et 14, où son débit d'introduction est contrôlé par les vannes 38, 40 et 27. En outre, un piège à azote liquide 39 est interposé entre l'enceinte 13 et la pompe 21. Dans la première enceinte 13, on réalise le dépôt d'oxyde, en l'occurence de la silice, en réglant les proportions d'oxygène et de monomère de silicone de manière à favoriser très nettement la formation de silice. Dans la deuxième enceinte, on règle les proportions d'oxygène et de monomère de silicone de manière à assurer un dépôt simultané de silice et de polymère. Enfin, dans la dernière enceinte 14, on réalise un dépôt de polymère pur, puisqu'on n'y introduit pas d'oxygène. Entre les couches de silice et de silicone on a donc formé une couche mixte, qui se rapproche de l'interface diffuse qu'il est possible de réaliser lors du traitement de pièces unitaires dans une enceinte unique, et qui favorise l'adhérence du silicone sur la silice. Les conditions opératoires et les temps de séjour du produit dans chaque enceinte sont calculés de manière à former des couches qui ont chacune l'épaisseur désirée.

On peut également prévoir plusieurs enceintes supplémentaires entre les enceintes 13 et 14, de manière à pouvoir créer une multiplicité de couches mixtes dont les teneurs en silicone iraient croissant au fur et à mesure de la progression du produit. On se rapprocherait ainsi encore davantage de l'interface diffuse.

Bien entendu, sans sortir de l'esprit de l'invention, on peut modifier les procédés et les dispositifs qui viennent d'être présentés, l'essentiel étant de parvenir à un produit final dont le revêtement comprend au moins une couche d'oxyde et une couche de polymère organique, et présente d'efficaces propriétés anti-corrosion. En particulier, on peut traiter des pièces de formes particulières en imposant aux électrodes des formes qui épousent la forme des pièces, de manière à garantir la régularité des épaisseurs des dépôts.

Enfin, l'invention s'applique non seulement au revêtement de pièces métalliques nues, mais aussi au revêtement de pièces déjà revêtues par une couche métallique, telles que des tôles galvanisées.

## Revendications

**1)** Procédé de revêtement d'un produit métallurgique, caractérisé en ce qu'on dépose en alternance sur la surface dudit matériau, au moyen de traitements superficiels de pulvérisation réactive utilisant un plasma froid généré dans une enceinte sous pression réduite, au moins une couche d'un oxyde métallique et au moins une couche d'un polymère organique.

**2)** Procédé selon la revendication 1, caractérisé en ce qu'on dépose ladite couche d'oxyde métallique par une méthode de pulvérisation cathodique réactive en courant continu.

**3)** Procédé selon la revendication 1, caractérisé en ce qu'on dépose lesdites couches d'oxyde métallique et de polymère organique par une méthode de pulvérisation réactive en courant alternatif.

**4)** Procédé selon la revendication 3, caractérisé en ce que ledit oxyde métallique est de la silice, en ce que ledit polymère organique est un silicone, en ce que lorsqu'on désire former une couche de silice on introduit dans ladite enceinte simultanément de l'oxygène et le monomère dudit silicone, et on règle leurs proportions respectives de manière à réaliser le dépôt de ladite couche de silice, et en ce que lorsqu'on désire former une couche de silicone, on introduit dans l'enceinte uniquement le monomère dudit silicone.

**5)** Procédé selon la revendication 4, caractérisé en ce que, entre les dépôts desdites couches d'oxyde et de silicone, on règle les proportions respectives de l'oxygène et dudit monomère de manière à réaliser un dépôt simultané de silice et de silicone formant une interface diffuse entre lesdites couches.

**6)** Dispositif pour le dépôt sur un produit métallurgique (5) d'un revêtement destiné à le protéger contre la corrosion, du type comprenant une enceinte (1) sous pression réduite renfermant ledit produit métallurgique (5) et équipée de moyens pour créer un plasma basse température en son intérieur comprenant deux électrodes (2,3) et un générateur de courant alternatif (4), caractérisé en ce qu'il comprend également des moyens (7) d'introduction dans l'enceinte à l'état gazeux du monomère d'un polymère organométallique, des moyens (9) d'introduction d'oxygène dans l'enceinte, et des moyens (8,10) de réglage des proportions respectives dudit monomère et de l'oxygène.

**7)** Dispositif pour le dépôt sur un produit métallurgique (28) d'un revêtement destiné à le protéger contre la corrosion, caractérisé en ce qu'il comprend au moins deux enceintes (13,14) sous pression réduite séparées l'une de l'autre de manière étanche, en ce que l'une au moins desdites enceintes (13,14) est pourvue de moyens (15,16,19) de production d'un plasma basse température assurant le dépôt sur ledit produit d'une couche d'un oxyde métallique, en ce que l'une au moins desdites enceintes (13,14) est pourvue de moyens (17,18,20) de production d'un plasma basse température assurant le dépôt sur le produit d'une couche d'un polymère organique, et en ce qu'il comprend des moyens (29,30) pour faire défiler en continu ledit produit successivement à l'intérieur desdites enceintes.

**8)** Dispositif selon la revendication 7, caractérisé en ce qu'il comprend, disposé entre lesdites enceintes (13,14) sur le parcours dudit produit, au moins une enceinte (31) sous pression réduite supplémentaire séparée desdites enceintes de manière étanche, pourvue de moyens (32,33,34) de production d'un plasma basse température permettant le dépôt simultané sur ledit produit d'un oxyde métallique et d'un polymère organique, et de moyens (27,37) pour régler les proportions relatives dudit oxyde et dudit polymère dans le revêtement.

**9)** Produit métallurgique, caractérisé en ce qu'il est revêtu par au moins une couche d'un oxyde métallique et au moins une couche d'un polymère organique superposées dans un ordre quelconque, et ayant été déposées sur ledit produit par une méthode de pulvérisation réactive utilisant un plasma froid.

**10)** Produit métallurgique selon la revendication 9, caractérisé en ce que lesdites couches sont séparées par une zone comprenant à la fois l'oxyde métallique et le polymère organique.

**11)** Produit métallurgique selon la revendication 10, caractérisé en ce que ladite zone est une interface diffuse.

**12)** Produit métallurgique selon l'une des revendications 9 à 11, caractérisé en ce que ledit oxyde est de la silice et ledit polymère un silicone.

**13)** Produit métallurgique selon la revendication 9, caractérisé en ce que ledit oxyde est un oxyde d'acier inoxydable, et ledit polymère un silicone.
